**Europäisches Patentamt**

**European Patent Office**

**Office européen des brevets**

(11) Numéro de publication: **0 148 687**

**B1**

(12) **FASCICULE DE BREVET EUROPÉEN**

(45) Date de publication du fascicule du brevet:
03.02.88

(51) Int. Cl.⁴: **H 01 L 31/02, H 01 L 27/14**

(21) Numéro de dépôt: **84402637.7**

(22) Date de dépôt: **18.12.84**

(54) **Dispositif photosensible comportant entre les détecteurs des zones opaques au rayonnement à détecter, et procédé de fabrication.**

(30) Priorité: **27.12.83 FR 8320842**

(43) Date de publication de la demande:
**17.07.85 Bulletin 85/29**

(45) Mention de la délivrance du brevet:
**03.02.88 Bulletin 88/5**

(84) Etats contractants désignés:
**DE GB SE**

(56) Documents cité:
**EP-A-0 024 970**
**US-A-3 577 175**
**US-A-4 355 456**

**PATENTS ABSTRACTS OF JAPAN, vol. 6, no. 151 (E-124) 1029 , 11 août 1982**
**IBM TECHNICAL DISCLOSURE BULLETIN, vol. 19, no. 11, avril 1977, pages 4101-4102, New York, US; J.D. TOMPKINS: "Solid-state optical scanner"**

(73) Titulaire: **THOMSON- CSF, 173, Boulevard Haussmann, F-75379 Paris Cédex 08 (FR)**

(72) Inventeur: **Henry, Yves, THOMSON CSF SCPI 173, bld Haussmann, F-75379 Paris Cedex 08 (FR)**
Inventeur: **Nicollet, André, THOMSON CSF SCPI 173, bld Haussmann, F-75379 Paris Cedex 08 (FR)**
Inventeur: **Reboul, Jean- Philippe, THOMSON CSF SCPI 173, bld Haussmann, F-75379 Paris Cedex 08 (FR)**
Inventeur: **Villard, Michel, THOMSON CSF SCPI 173, bld Haussmann, F-75379 Paris Cedex 08 (FR)**

(74) Mandataire: **Mayeux, Michèle, THOMSON- CSF SCPI 19, avenue de Messine, F-75008 Paris (FR)**

## Description

La présente invention concerne un dispositif photosensible comportant entre les détecteurs des zones opaques au rayonnement à détecter. Elle concerne également un procédé de fabrication d'un tel dispositif.

Les détecteurs dont il est question sont généralement des photo-diodes ou des photo-MOS, intégrés dans un même substrat semi-conducteur.

Comme cela a été expliqué dans la demade de brevet EP-A-0 024 970 au nom de THOMSON-CSF, dans certaines applications, on est conduit à diminuer les dimensions des détecteurs. Il arrive alors que l'on constate "un effet de bord", c'est-à-dire que la zone sur laquelle le rayonnement reçu par un détecteur produit ses effets devienne sensiblement supérieure à la surface du détecteur, ce qui limite la dimension minimale que l'on peut consacrer à chaque détecteur.

Cet "effet de bord" se manifeste notamment dans les substrats semi-conducteurs sensibles au rayonnement infra-rouge. Il s'agit soit de matériaux binaires tels que l'antimoniure d'indium, In Sb, le tellure de plomb, Pb Te..., soit de matériaux ternaires tels que le tellurure de mercure et de cadmium, Cd Hg Te ou le tellurure d'étain et de plomb, Pb Sn Te. On observe cet "effet de bord" d'une façon plus générale lorsqu'on utilise un substrat semi-conducteur à haute mobilité; c'est ainsi le cas par exemple des semi-conducteurs, constitués de composés des familles III et V, tels que l'arséniure de gallium, As Ga, ou le phosphure d'indium, P In.

Pour combattre cet "effet de bord", tout en conservant aux détecteurs de faibles dimenisons, diverses solutions ont été utilisées dans l'art antérieur pour créer entre les détecteurs des zones opaques au rayonnement à détecter.

Dans la demade de brevet EP-A-0 024 970 déjà citée, on utilise comme masque pour réaliser ces zones opaques, la résine photosensible - référence 3 sur les figures 1 et 2 de ce brevet- servant à délimiter les zones réservées aux photo-diodes mésa. Cette solution présente les inconvénients suivants:
- la géométrie des zones recouvertes de résine photosensible détermine impérativement les dimensions des zones opaques et celles des détecteurs;
- on dépose une couche mince 5, opaque au rayonnement, par exemple par évaporation. Il peut s'agir d'une couche d'isolant, mais ce dépôt fait que l'isolant est chargé électriquement et que les jonctions photo-voltaïques des détecteurs ne sont pas stabilisées électriquement au maximum;
- comme le dépôt des couches opaques au rayonnement se fait par auto-indexation sur les zones recouvertes de résine photosensible, il est impossible de cacher les bords des jonctions. Les détecteurs présentent donc une sensibilité accrue sur les bords des jonctions, ce qui est un inonvénient.

Une autre solution connue de l'art antérieur est de réaliser des électrodes dites de champ.

Dans ce cas, on realise des jonctions dans le substrat semi-conducteur que l'on recouvre d'oxyde. Par des fenêtres percées à travers l'oxyde, on dépose des électrodes en contact avec le substrat. Ces électrodes sont soumises à un potentiel et en même temps leur géométrie détermine celle des zones opaques au rayonnement séparant les détecteurs.

L'inconvénient de cette solution, ce sont les risques de claquage de l'oxyde, qui est intercalé entre le substrat semi-conducteur et l'électrode de champ qui sont portés à des potentiels différents.

La présente invention concerne un dispositif photosensible comportat entre les detecteurs des zones opaques au rayonnement qui supprime les inconvénients, des solutions connues de l'art antérieur.

La présente invention concerne un dispositif photosensible comportant des détecteurs intégrés dans un même substrat semi-conducteur avec, entre les détecteurs, des zones opaques au rayonnement à détecter, caractérisé en ce que la surface du substrat est recouverte des trois couches suivantes;
- une première couche d'oxyde anodique qui recouvre toute la surface du substrat;
- une deuxième couche, constituée par au moins une couche de métal opaque au rayonnement à détecter, qui ne recouvre que lesdites zones opaques au rayonnement;
- une troisième couche en matériau diélectrique recouvrant toute la surface.

Le dispositif selon l'invention n'est pas obtenu par auto-indexation comme c'est le cas pour le dispositif de la demande EP-A-0 024 970. L'invention permet de faire varier sans difficulté la surface des détecteurs photosensibles.

L'utilisation d'une première couche d'oxyde anodique recouvrant tout le substrat semi-conducteur permet une stabilisation parfaite des jonctions photo-voltaïques. Cela tient aux qualités propres aux oxydes anodiques; en particulier, il suffit d'une couche d'oxyde de faible épaisseur, d'environ 10 à 60 nm (100 à 600 Å) par exemple, pour obtenir ces résultats.

Dans le dispositif selon l'invention, on peut sans difficulté recouvrir les bords des jontions, car la première couche isolante s'étend sur tout le substrat et la deuxième couche, opaque au rayonnement à détecter, est gravée par photo-lithogravure, ce qui permet de choisir librement les zones où l'on désire conserver cette deuxième couche.

Dans le dispositif selon l'invention, il n'y a pas de risque de claquage de la première couche isolante car la deuxième couche métallique ne reçoit pas de tension et se trouve recouverte par une couche isolante.

Enfin, un avantage du dispositif selon l'invention est que les zones opaques au rayonnement présentent une surface isolante que l'on peut utiliser sans risque de court-circuit pour le passage de diverses connexions.

Das un exemple d'utilisation bien déterminé, le dispositif selon l'invention permet de rapprocher deux photodiodes à 50 μm l'une de l'autre sans trop de problème d'intermodulation, alors que dans l'art antérieur il faut au moins 100 μm. Ces chiffres correspondent à l'exemple d'un substrat semi-conducteur en antimoniure d'indium, de type N, placé à 77 degrés Kelvin, comprenant $5.10^{15}$ porteurs de charges majoritaires par centimètre cube, pour lequel a durée de vie des trous est d'environ $2.10^{-7}$ secondes, leur mobilité est d'environ 4000 cm$^2$ par Volt et par seconde, ce qui correspond à un coefficient de diffusion denviron 26 cm$^2$ par seconde et à une longueur de diffusion Lp d'environ 23 μm. On admet dans cet exemple une loi de décroissance du signal en fonction de la distance x au point d'absorption d'un photon de la forme: $I = I_0.e^{-x/Lp}$. A une distance de 60 μm du bord d'une jontion, le signal est encore égal à 0,07. $I_0$; le dispositf selon l'invention permet donc de rapprocher deux photodiodes à 50 μm l'une de l'autre sans problème.

Le même exemple pour un substrat d'antimoniure d'indium de type P montre que'à une distance de 60 μm, du bord d'une jonction, le signal est pratiquement nul. Le dispositif selon l'invention permet dans ce cas de rapprocher deux photo-diodes de 15 μm l'une de l'autre environ.

Le dispositif selon l'invention permet donc d'augmenter la résolution par rapprochement des détecteurs, tout en limitant le couplage optique entre les détecteurs.

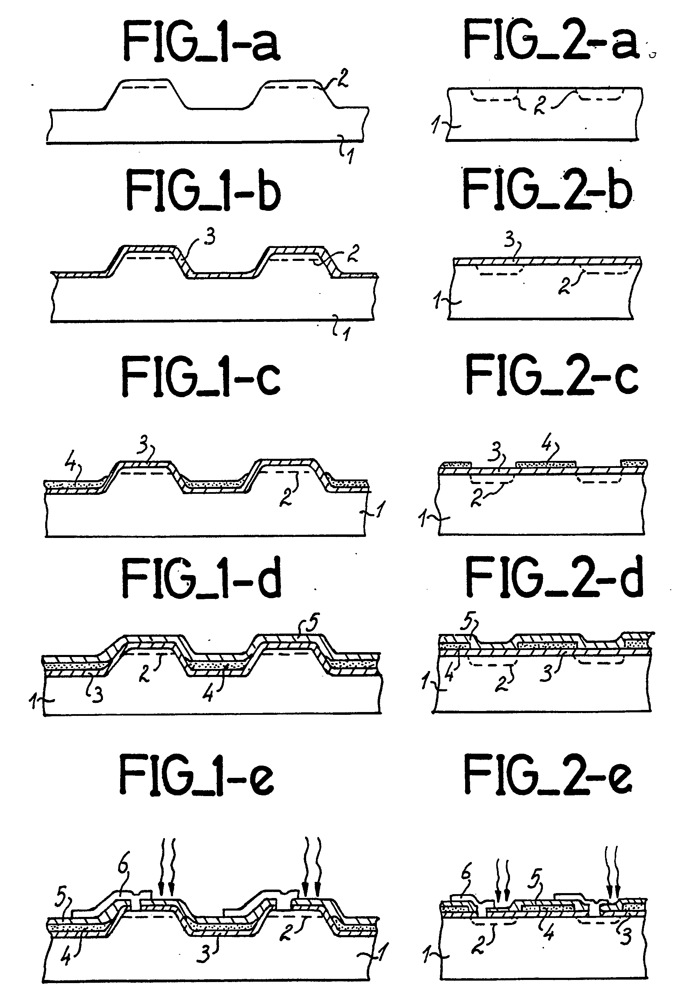

D'autres objets, et caractéristiques et résultats de l'invention ressortiront de la description suivante, donné à titre d'exemple non limitatif et illustrée par les figures 1a à e et 2a à e qui représentent diverses étapes d'un procédé de fabrication d'un mode de réalisation d'un dispositif selon l'invention, dans le cas d'une structure mésa sur les figures 1a à e et das le cas d'une structure planar sur les figures 2a à e.

Sur les différentes figures, les mêmes repères désignent les mêmes éléments, mais, pour des raisons de clarté, les cotes et proportions de divers éléments ne sont pas respectées.

Sur les figures 1a à e, on a représenté diverses étapes d'un procédé de fabrication d'un mode de réalisation d'un dispositif selon l'invention.

On réalise sur un substrat semi-conducteur 1 des jonctions photo-voltaïques 2, de type N/P ou P/N, représentées symboliquement sur la figure 1a par des pointilés.

Sur la figure 1a, on a représenté des diodes du type mésa.

On fait croître un oxyde par oxydation anodique sur toute la surface du substrat - voir figure 1b. Cette première couche d'oxyde porte la référence 3. Son épaisseur est d'environ 10 à 60 nm (100 à 600 Å). La croissance de l'oxyde anodique se fait, par exemple, par électrolyse. Dans le cas d'un substrat semi-conducteur en atimoniure d'indium, on peut par exemple plonger le substrat dans une solution de potasse dont il constitue l'anode, alors que comme cathode, on utilise par exemple un fil de platine. L'oxyde obtenue est riche en oxydes d'indium. Il faut remarquer que l'analyse du produit obtenu révèle que le dépôt d'oxyde a été effectué par oxydation anodique. En particulier, l'oxyde d'indium déposé par évaporation est conducteur alors que l'oxyde d'indium anodique est un très bon diélectrique.

On dépose ensuite sur la première couche d'oxyde anodique 3 une deuxième couche 4 opaque au rayonnement à détecter - voir figure 1c.

Dans le cas d'un rayonnement visible cette deuxième couche n'est pas obligatoirement métallique. Un corps tel que le pentaséléniure d'arsenic, As$_2$ Se$_5$ est opaque au rayonnement visible.

Dans le cas d'un rayonnement infra-rouge, il faut que la deuxième couche soit métallique, elle peut être par exemple en or ou en aluminium.

En fait, on a constaté que le dépôt d'une couche d'or sur la couche d'oxyde anodique n'est pas entièrement satisfaisant car l'or "n'accroche" pas très bien sur l'oxyde. On peut utiliser une deuxième couche 4, constituée par la superposition d'au moins une première et une deuxième couches métalliques élémentaires. La première couche métallilque élémentaire est constituée d'un métal assurant un bon contact, un bon "accrochage", avec la couche d'oxyde anodique et avec la deuxième couche métallique élémentaire. On peut utiliser un métal de la famille du chrome, du titane, du nickel ou du molybdène... par exemple. Ces métaux sont trasparents à l'infrarouge, ce qui justifie l'utilisation d'une deuxième couche élémentaire en or, ou en aluminium par exemple, si l'on veut détecter un rayonnement infra -rouge.

La deuxième couche 4 opaque au rayonnement à détecter peut être constituée par la superposition de plusieurs couches élémentaires.

Cette deuxième couche 4 est gravée par photo-lithogravure par exemple, pour ne recouvrir que les zones que l'on souhaite rendre opaques au rayonnement à détecter.

On voit sur la figure 1c le résultat de cette gravure.

On peut ne laisser subsister la couche 4 qu'entre les détecteurs. On peut aussi la laisser s'étendre sur une partie des détecteurs.

Cette deuxième couche a une épaisseur d'environ 100 à 600 nm (1000 à 6000 Å) par exemple. Elle peut être déposée par exemple par évaporation sous vide ou pulvérisation cathodique.

Sur cette deuxième couche 4, on dépose une troisième couche 5 - voir figure 1d - en matériau diélectrique, qui recouvre toute la surface. Il peut s'agir d'un isolat organique ou non, par exemple de la résine photosensible négative ou du monoxyde de silicium, Si O.

Cette dernière couche peut être déposée par exemple par évaporation sous vide, pulvérisation cathodique, dépôt ionique, induction au trempé,

centrifugation...

Son épasseur peut être par exemple de l'ordre du μm.

Sur la figure 1e, on montre que l'on peut réaliser des connexions metalliques 6 en contact avec les jonctions 2 par des fenêtres traversat les première, et troisième couches. Ces connexions 6 sont disposées sur la troisième couche 5. On peut utiliser des connexions en métal opaque au rayonnement à détecter et qui modifient donc la géométrie des zones photosensibles.

Les figures 2a à e ne diffèrent des figures 1a à e que parce qu'elles montrent des diodes à structure planar.

Il est bien entendu que l'invention s'applique quelle que soit la structure planar ou mésa des détecteurs.

## Revendications

1. Dispositif photosensible comportant des détecteurs intégrés dans un même substrat semi-conducteur (1), avec entre les détecteurs, des zones opaques au rayonnement à détecter, caractérisé en ce que la surface du substrat est recouverte des trois couches suivantes;
- une première couche (3) d'oxyde anodique qui recouvre toute la surface du substrat;
- une deuxième couche (4), constituée par au moins une couche de métal opaque au rayonnement à détecter, qui ne recouvre que lesdites zones opaques au rayonnement;
- une troisième couche (5) en matériau diélectrique recouvrant toute la surface.

2. Dispositif selon la revendication 1 caractérisé en ce que le métal opaque au rayonnement à détecter est de l'or ou de l'aluminium.

3. Dispositif selon l'une des revendications 1 ou 2, caractérisée en ce que la deuxième couche (4) est constituée par la superposition d'au moins une première et une deuxième couches métalliques élémentaires, la première couche élémentaire en métal assurant un bon contact d'une part avec l'oxyde anodique et d'autre part avec la deuxième couche élémentaire, en métal opaque au rayonnement à détecter.

4. Dispositif selon la revendication 3 caractérisé en ce que le métal assurant un bon contact est de la famille du chrome, du titane, du nickel ou du molybdène.

5. Dispositif selon l'une des revendication 1 à 4, caractérisé en ce que la troisième couche (5) est en résine photosensible négative ou en monoxyde de silicium.

6. Dispositif selon l'une des revendications 1 à 5, caractérisé en ce que le substrat semi-conducteur (1) est un matériau sensible à l'infra-rouge tel que l'atimoniure d'indium, ou le tellurure de plomb et d'étain, ou est constitué d'un composé des groupes III et V tel que l'arséniure de gallium ou le phosphure d'indium.

7. Dispositif selon l'une des revendications 1 à 6, caractérisé en ce que la couche d'oxyde anodique (3) a une épasseur d'environ 10 à 60 nm, la deuxième couche (4) a une épasseur d'environ 100 à 600 nm et la trosième couche (5) à une épasseur de l'ordre du micromètre.

8. Dispositif selon l'une des revendications 1 à 7, caractérisé en ce qu'il comporte des connexions métalliques (6) en contact avec le substrat par une fenêtre réalisée à travers la première, et la troisième couches, situées sur la troisième couche (5) et opaques au rayonnement à détecter.

9. Procédé de fabrication d'un dispositif photosensible selon l'une des revendications 1 à 8, caractérisé en ce qu'il comporte les étapes suivantes:
   a) on réalise des jonctions (2) dans le substrat semi-conducteur (1);
   b) on fait croître un oxyde (3) à la surface du substrat par oxydation anodique;
   c) on dépose au moins une couche métallique (4) opaque au rayonnement à détecter;
   d) on grave cette couche par qu'elle ne recouvre que lesdites zones opaques au rayonnement à détecter;
   e) on dépose une couche de matériau diélectrique (5) sur toute a surface.

10. Procédé selon la revendication 9, caractérsé en ce que le dépôt (4) de l'étape c est réalisé par évaporation sous vide ou pulvérsation cathodique.

11. Procédé selon l'une des revendications 9 ou 10 caractérsé en ce que lors de l'étape c on dépose au moins une première et une deuxième couches métalliques élémentaires, la première couche élémentaire étant en métal assurant un bon contact d'une part avec l'oxyde anodique et d'autre part avec la deuxième couche élémentaire, en métal opaque au rayonnement à détecter.

12. Procédé selon l'une des revendications 9 à 11, caractérisé en ce que lors de l'étape d, la couche métallique (4) est gravée par photo-lithogravure.

13. Procédé selon l'une des revendications 9 à 12, caractérsé en ce que le dépôt de l'étape (e) est réalisé par évaporation sous vide, pulvérsation cathodique, dépôt ionique, enduction au trempé ou centrifugation.

## Patentansprüche

1. Lichtempfindliche Vorrichtung mit Detektoren, die in ein gemeinsames Halbleitersubstrat (1) integriert sind, wobei zwischen den Detektoren für die zu erfassende Strahlung undurchlässige Zonen liegen, dadurch gekennzeichnet, daß die Oberfläche des Substrats mit den drei folgenden Schichten bedeckt ist, nämlich
   - einer ersten anodisches Oxidschicht (3), die die ganze Oberfläche des Substrats bedeckt,
   - einer zweiten Schicht (4), die aus mindestens einer für die zu erfassende Strahlung undurchlässigen Metallschicht besteht und nur die für die Strahlung undurchlässigen Zonen bedeckt,

- einer dritten Schicht (5) aus einem dielektrischen Material, die die ganze Oberfläche bedeckt.

2. Vorrichtung nach Anspruch 1, dadurch gekennzeichnet, daß das für die zu erfassende Strahlung undurchlässige Metall Gold oder Aluminium ist.

3. Vorrichtung nach einem der Ansprüche 1 oder 2, dadurch gekennzeichnet, daß die zweite Schicht (4) durch Überlagerung mindestens einer ersten und einer zweiten elementaren Metallschicht gebildet wird, wobei die erste Elementarschicht aus Metall einen guten Kontakt einerseits mit dem anodischen Oxid und andererseits mit der zweiten Elementarschicht aus einem für die zu erfassende Strahlung undurchlässigen Metall sichert.

4. Vorrichtung nach Anspruch 3, dadurch gekennzeichnet, daß das Metall, das einen guten Kontakt sichert, aus der Gruppe ausgewählt wird, die Chrom, Titan, Nickel und Molybdän enthält.

5. Vorrichtung nach einem der Ansprüche 1 bis 4, dadurch gekennzeichnet, daß die dritte Schicht (5) aus einem negativen lichtempfindlichen Harz oder einem Siliziummonoxid besteht.

6. Vorrichtung nach einem der Ansprüche 1 bis 5, dadurch gekennzeichnet, daß das halbleitende Substrat (1) ein für Infrarotlicht empfindliches Material wie z. B. Indiumantimonid oder Bleitellurid oder Zinntellurid ist oder aus einer Verbindung der Gruppen III und V wie z. B. Galliumarsenid oder Indiumphosphid besteht.

7. Vorrichtung nach einem der Ansprüche 1 bis 6, dadurch gekennzeichnet, daß die anodische Oxidschicht (3) eine Dicke von zwischen 10 und 60 nm besitzt, die zweite Schicht (4) eine Dicke von zwischen 100 und 600 nm und die dritte Schicht (5) eine Dicke in der Größenordnung eines Mikrometers besitzt.

8. Vorrichtung nach einem der Ansprüche 1 bis 7, dadurch gekennzeichnet, daß sie metallische Anschlüsse (6) aufweist, die mit dem Substrat über ein durch die erste Schicht und die dritte Schicht hindurchreichendes Fenster in Kontakt stehen, auf der dritten Schicht (5) angeordnet sind und für die zu erfassende Strahlung undurchlässig sind.

9. Verfahren zur Herstellung einer lichtempfindlichen Vorrichtung nach einem der Ansprüche 1 bis 8, dadurch gekennzeichnet, daß es folgende Verfahrensschritte aufweist:

a) es werden Verbindungszonen (2) in dem halbleitenden Material (1) hergestellt;

b) man läßt ein Oxid (3) auf der Oberfläche des Substrats durch anodische Oxidation wachsen;

c) man bringt mindestens eine Metallschicht (4) auf, die für die zu erfassende Strahlung undurchlässig ist;

d) diese Schicht wird so graviert, daß sie nur die für die zu erfassende Strahlung undurchlässigen Zonen abdeckt;

e) man bringt eine Schicht aus dielektrischem Material (5) auf die ganze Oberfläche auf.

10. Verfahren nach Anspruch 9, dadurch gekennzeichnet, daß die Schicht (4) des Verfahrensschritts c durch Verdampfung im Vakuum oder Kathodenzerstäubung aufgebracht wird.

11. Verfahren nach einem der Ansprüche 9 oder 10, dadurch gekennzeichnet, daß während des Verfahrensschritts c mindestens eine erste und zweite elementare Metallschicht aufgebracht werden, wobei die erste Elementarschicht aus einem Metall ist, das einen guten Kontakt einerseits mit dem anodischen Oxid und andererseits mit der zweiten Elementarschicht sichert, die aus einem für die zu erfassende Strahlung undurchlässigen Metall besteht.

12. Verfahren nach einem der Ansprüche 9 bis 11, dadurch gekennzeichnet, daß während des Verfahrensschritts d die Metallschicht (4) durch Foto-Lithogravur graviert wird.

13. Verfahren nach einem der Ansprüche 9 bis 12, dadurch gekennzeichnet, daß die Schicht des Verfahrensschritts (e) durch Verdampfung im Vakuum, Kathodenzerstäubung, Ionenabscheidung, Tränken durch Eintauchen oder Zentrifugieren hergestellt wird.

## Claims

1. A photosensitive device comprising detectors which are integrated in a common semiconducting substrate (1), with zones between the detectors which are opaque to the radiation to be detected, characterized in that the surface of the substrate is coated with the three following layers:

- a first layer (3) of an anodic oxide which covers the entire substrate surface;
- a second layer (4) constituted by at least one metal layer which is opaque to the radiation to be detected and which covers only said zones which are opaque to the radiation;
- a third layer (5) made of a dielectric material and covering the entire surface.

2. A device according to claim 1, characterized in that the metal which is opaque to the radiatioon to be detected is gold or aluminium.

3. A device according to one of claims 1 or 2, characterized in that the second layer (4) is constituted by the superposition of at least a first and a second elementary metal layer, the first elementary metal layer ensuring a good contact on the one hand with the anodic oxide and on the other hand with the second elementary layer made of a metal which is opaque to the radiation to be detected.

4. A device according to claim 3, characterized in that the metal ensuring a good contact is chosen from the group consisting of chromium, titanium, nickel or molybdenium.

5. A device according to one of claims 1 to 4, characterized in that the third layer (5) is made of a negative photosensitive resin or from a silicium monoxide.

6. A device according to one of claims 1 to 5, characterized in that the semiconducting substrate (1) is a material which is sensitive to the infrared light, such as indium antimonide or lead telluride or tin telluride or is constituted by a compound of the groups III and V such as gallium arsenide or indium phosphide.

7. A device according to one of claims 1 to 6, characterized in that the layer of anodic oxide (3) has a thickness of between 10 and 60 nm, that the second layer (4) has a thickness of between 100 and 600 nm and that the third layer (5) has a thickness of about one micrometer.

8. A device according to one of claims 1 to 7, characterized in that it comprises metal connections (6) in contact with the substrate through a window realized through the first and the third layers, these connections being located on the third layer (5) and being opaque to the radiation to be detected.

9. A method for manufacturing a photosensitive device according to one of claims 1 to 8, characterized in that it comprises the following steps:

a) junctions (2) are realized in the semiconducting substrate (1);

b) an oxide (3) is made to grow on the substrate surface by anodic oxidation;

c) at least one metal layer (4) which is opaque to the radiation to be detected is deposited;

d) this layer is engraved such that it only covers said zones which are opaque to the radiation to be detected;

- e) a layer of dielectric material (5) is deposited on the entire surface.

10. A method according to claim 9, characterized in that the layer (4) of the step c is realized by evaporation under vacuum or by cathode pulverisation.

11. A method according to one of claims 9 or 10, characterized in that during the step c, at least a first and a second elementary metal layer are deposited, the first elementary layer being made of a metal which ensures a good contact on the one hand with the anodic oxide and on the other hand with the second elementary layer, the latter being of a metal which is opaque to the radiation to be detected.

12. A method according to one of claims 9 to 11, characterized in that during the step d, the metal layer (4) is engraved by a photo-litho-engraving method.

13. A method according to one of claims 9 to 12, characterized in that the layer of step (e) is realized by evaporation under vacuum, cathode pulverisation, ion deposition, dipping or centrifugation.

0 148 687

FIG_1-a

FIG_2-a

FIG_1-b

FIG_2-b

FIG_1-c

FIG_2-c

FIG_1-d

FIG_2-d

FIG_1-e

FIG_2-e

1